# EUROPEAN PATENT APPLICATION

(11) **EP 4 680 001 A1**
(43) Date of publication of application: **14.01.2026**
(21) Application number: 24315342.6
(22) Date of filing: 12.07.2024
(51) Int. Cl.: H10N 60/01, C23C 16/54, C23C 14/00

(54) **APPARATUS AND METHOD FOR DEPOSITION OF A HIGH TEMPERATURE SUPERCONDUCTOR ON A SUBSTRATE**

(71) Applicant: Renaissance Fusion, 38600 Fontaine (FR)
(72) Inventor: Volpe, Francesco, 38600 FONTAINE (FR); Usoskin, Alexander, 38600 FONTAINE (FR)
(74) Representative: Cabinet Beaumont

(57) **Abstract**

The present disclosure relates to a deposition apparatus (100) for depositing a high temperature superconductor material onto a first surface (11) of at least one substrate (10), the deposition apparatus comprising:
- a deposition chamber (101) comprising side walls (111, 112);
- a substrate transport system for transporting the at least one substrate in the deposition chamber along one or more of the side walls;
- a heating system for heating the at least one substrate in the deposition chamber at a first temperature;
- a precursor inlet (160) for delivering a gas flow (20) including an HTS material precursor into the deposition chamber;
wherein the side walls of the deposition chamber are arranged in such a way that, when the at least one substrate is transported along the one or more side walls of the deposition chamber, a first part (11A) of the first surface faces a second part (11B) of the first surface.

## Description

### Technical field

The present disclosure relates generally to deposition apparatuses, and more particularly to apparatuses for deposition of a high temperature superconductor (HTS) material on a substrate.

The present disclosure also relates generally to deposition methods, and more particularly to methods for depositing an HTS material on a substrate.

The present disclosure finds particular applications for wide and long substrates.

### Background art

High temperature superconductors (HTS) provide a potential for development of superconductor components at higher operating temperatures compared to traditional superconductors that operate for example at liquid helium temperature (4.2K). High temperature superconductors are materials that exhibit superconducting properties at temperatures generally above 77 K, the boiling point of nitrogen. High temperature superconductors may exhibit a resistance practically of zero under specific superconducting conditions, which is usually a matter of being at the right temperature. Having "zero" resistance, currents can flow freely and at high current density through these superconducting materials. Ultimately this makes it possible to produce magnetic fields of high strength and with specific characteristics as required by some applications.

Examples of HTS materials comprise Yttrium Barium Copper Oxides (YBCO), which are oxide-based superconductors. Other examples of HTS materials have a similar chemical composition as YBCO materials but with Y replaced by other rare earth elements. This family of HTS materials is often denoted as Rare-Earth Barium Copper Oxide (REBCO), where RE may include Y, La, Nd, Sm, Eu, Gd, Sc, Tb, Dy, Ho, Er, Tm, Yb or Lu.

An HTS material may be deposited as a thin film on a substrate, for example a metallic substrate, which may be a substrate tape, or a cylindrical substrate. The thin film may include one or more buffer layer(s) onto the substrate, between the substrate and the HTS layer, for example to prevent reaction between the substrate and the HTS layer, and/or to provide a template for a growth of highly textured HTS layer. In order to optimize this growth, the substrate may comprise one or more buffer layer(s) onto which the HTS layer is deposited.

One technique that exists for the formation of an HTS layer is a chemical vapor deposition (CVD) technique, in particular a metal-organic chemical vapor deposition (MOCVD) technique. The MOCVD technique typically comprises delivering a metal-organic precursor material in a vapor phase to the substrate for deposition. Generally, the precursor material is delivered together with a carrying gas. The substrate is generally heated to a high temperature, for example to a temperature comprised between 700°C and 900°C, or between 750°C and 850°C, in order the vapor phase precursor material to be deposited on the substrate, and the HTS layer to be grown on the substrate.

One type of conventional reactor which may be used to carry out a MOCVD process is a cold-wall reactor. An example of a cold-wall reactor is described in patent application WO2022/182967A1. In patent application WO2022/182967A1, the reactor comprises a deposition chamber which is preferably maintained under vacuum conditions and having a precursor inlet. During its translation in the deposition chamber, a substrate is supported and heated by a plate-shaped susceptor positioned in the deposition chamber, the susceptor having internal heater elements. Only the susceptor is heated, the walls of the reactor and of the deposition chamber being not directly heated, so that the vapor phase precursor material does not react before reaching the heated substrate. The walls of the deposition chamber, however, may be indirectly heated by heat radiating from the susceptor, but generally remains cooler than the susceptor and the substrate on the susceptor. Another example of a hot-wall reactor is described in patent EP1694432B1.

Another type of conventional reactor which may be used to carry out a MOCVD process is a hot-wall reactor. In a hot-wall reactor, all or part of the walls of the deposition chamber are heated. Patent EP1694432B1 cited above describes the use of a hot-wall chamber, in which, for example the heater of the substrate may be a furnace which is adapted to heat the substrate through the walls of the chamber. This type of reactor may be necessary for example for some vapor phase precursor material to be pre-heated or pre-cracked before reaching the substrate.

Each of the conventional reactors, such as the cold-wall and hot-wall reactors mentioned above, may be adapted for long and narrow substrates, for example long and narrow substrate tapes. However, the HTS deposition throughput may be limited by several factors. In particular, above a certain width of the substrate, for example above 5 centimeters, there may be limitations and issues appearing using conventional reactors. High heat losses may occur, in particular in a conventional cold-wall reactor. These heat losses can reach around ten kW, or even around a hundred kW for 100 cm wide substrate tapes. One reason for this is that at high temperatures, for example between 700°C and 900°C, as used particularly for HTS deposition, infrared (IR) radiation from both the heater/susceptor and the growing HTS layer has a significant impact on heat losses. Thus, the deposition surface of the substrate may experience a temperature change along the width and/or the length of the substrate. This may result in a non-uniformity of temperature along the width, and possibly along the length, of the substrate, and possibly in a non-uniformity of the (i) thickness, (ii) composition, as well as (iii) crystallinity, of the material deposited onto the substrate. In addition, significant losses of deposition material, since this material may start to be chemically active not only near the substrate but also near the heated walls, can occur, particularly in a conventional hot-wall reactor.

Thus, there remains a need for HTS deposition apparatus and method which allow long and wide substrates, and that, preferentially under efficient energy conditions, that is, with reduced heat losses.

The HTS deposition apparatus and method may advantageously capable of providing a sufficient uniformity of temperature along the width, and possibly along the length, of the substrate, and that, even for a wide substrate, for example wider than 10 cm or even wider than 100 cm.

It may also be advantageous to provide HTS deposition apparatus and method with high throughput capabilities even onto wide substrates, for example wider than 10 cm or even wider than 100 cm.

It may also be advantageous to provide HTS deposition apparatus and method with reduced deposition material losses and/or reduced amount of by-products, without for that having to limit the length and/or the width of the deposition surface of the substrate.

### Summary of Invention

One embodiment addresses all or some of the drawbacks of known deposition HTS apparatuses and methods.

One embodiment provides a deposition apparatus for depositing a high temperature superconductor material onto a first surface of at least one substrate, the deposition apparatus comprising:
- a deposition chamber comprising side walls ;
- a substrate transport system for transporting the at least one substrate in the deposition chamber along the side walls;
- a heating system for heating the at least one substrate in the deposition chamber at a first temperature;
- a precursor inlet for delivering a gas flow including an HTS material precursor into the deposition chamber;
wherein the side walls of the deposition chamber are arranged in such a way that, when the at least one substrate is transported along the side walls of the deposition chamber, a first part of the first surface faces a second part of the first surface.

One embodiment provides a method for depositing a high temperature superconductor material (HTS) onto a first surface of at least one substrate, the method comprising:
- transporting the at least one substrate in a deposition chamber, along side walls of said deposition chamber, using a substrate transport system; the side walls of the deposition chamber being arranged in such a way that, during the transport of the at least one substrate in the deposition chamber, a first part of the first surface faces a second part of the first surface;
- heating the at least one substrate in the deposition chamber at a first temperature, using a heating system;
- delivering a gas flow including an HTS material precursor into the deposition chamber, using a precursor inlet;
wherein the transport of the at least one substrate in the deposition chamber is performed in such a way that an infrared emission between both first and second parts of the first surface is confined between said first and second parts.

The following embodiments may apply both to the deposition apparatus and to the method.

In one embodiment, the heating system is adapted to heat a second surface,of the at least one substrate different from the first surface, for example a second surface opposite the first surface.

In one embodiment, the heating system comprises a thermal heating source adapted to heat the at least one substrate via an infrared radiation, for example the thermal ' heating source:
- is distributed over the width of each of the at least one substrate; and/or
- has no direct thermal conductive contact with each of the at least one substrate; and/or
- is configured to follow the shape of the at least one substrate in the deposition chamber.

In one embodiment, the heating system comprises heating elements, for example heating wires, integrated into the side walls, the side walls forming heating walls.

In one embodiment, the at least one substrate comprises a substrate tape.

In one embodiment, the side walls of the deposition chamber comprise a first side wall and a second side wall facing the first side wall, for example a ratio between the distance between the first wall and the second wall to the smallest dimension, for example the width, of the at least one substrate in the deposition chamber is lower than 0.33 or even lower than 0.1, and/or the distance between the first wall and the second wall varying in the direction of the gas flow in the deposition chamber.

In one embodiment, the deposition chamber has a trapezoidal-prism or a parallelepipedal shape, the deposition chamber further comprises a third wall joining the first and second side walls, the third wall for example facing an open end of the deposition chamber.

In one embodiment, a first distance between the first wall and the second wall at an open end of the deposition chamber facing the third wall is lower than a second distance between the first wall and the second wall at the third wall of the deposition chamber.

In one embodiment, the deposition chamber has a ring shape or a spiral shape.

In one embodiment, the first side wall is an inner side wall, and the second side wall is an outer side wall positioned around the inner side wall, the inner and outer walls being at least partially tubular, for example the inner and outer walls being at least partially coaxial.

In one embodiment, the at least one substrate comprises a substrate tape which is adapted to translate along one of-the-inner and outer side walls on a way out and along the other one of the inner and outer side walls on a way back, the first part corresponding to a portion of the substrate tape which is on the way out and the second part corresponding to another portion of the substrate tape which is on the way back.

In one embodiment, the at least one substrate comprises a substrate tape which is adapted to translate along one of the inner and outer side walls, and a tubular substrate which is adapted to translate along the other one of the inner and outer side walls, the first part corresponding to the deposition surface of the substrate tape and the second part corresponding to the deposition surface of the tubular substrate.

In one embodiment, the transport system comprises a plurality of guiding rollers arranged in such a way to guide the at least one substrate along the side walls of the deposition chamber, for example at least one of the guiding rollers being positioned inside the deposition chamber and at least another one of the guiding rollers being positioned outside the deposition chamber.

In one embodiment, at least one of the guiding rollers is permeable to the gas flow, for example at least one of the guiding rollers comprises through-holes through which the gas flow is adapted to be removed from the deposition apparatus.

In one embodiment, a closed chamber outside the deposition chamber and in contact with one or more of the side walls of the deposition chamber is under vacuum, for example a vacuum lower than 10⁻⁴ mbar.

In one embodiment, a cover wall is positioned over an open end of the deposition chamber, the cover wall being heated, for example with heating elements embedded in said cover wall, at a second temperature lower than the first temperature, for example the cover wall is traversed by the precursor inlet.

In one embodiment, an infrared shielding is positioned around the deposition chamber.

### Brief description of drawings

The foregoing features and advantages, as well as others, will be described in detail in the following description of specific embodiments given by way of illustration and not limitation with reference to the accompanying drawings, in which:
Figure 1A schematically illustrates, in a cross-section view, a deposition apparatus according to an embodiment;
Figure 1B schematically illustrates, in another cross-sectional view, a detail of the deposition apparatus of Figure 1A;
Figure 2 schematically illustrates, in a cross-sectional view, a variant of the deposition apparatus of Figure 1A;
Figure 3 schematically illustrates, in a cross-section view, a deposition apparatus according to another embodiment;
Figure 4 schematically illustrates, in a cross-section view, a deposition apparatus according to a variant of the deposition apparatus of Figure 3;
Figure 5 schematically illustrates, in a cross-section view, a deposition apparatus according to another variant of the deposition apparatus of Figure 3; and
Figure 6 schematically illustrates, in a cross-section view, a deposition apparatus according to another embodiment.

### Description of embodiments

Like features have been designated by like references in the various figures. In particular, the structural and/or functional features that are common among the various embodiments may have the same references and may dispose identical structural, dimensional and material properties.

For the sake of clarity, only the operations and elements that are useful for an understanding of the embodiments described herein have been illustrated and described in detail. Only important details of the embodiment are illustrated and described, however one of ordinary skill in the art can appreciate how the overall apparatus may be constructed, without undue experimentation. Some details may have been omitted from the figures, but the inventors believe that adding these details is unnecessary for the overall appreciation of the characteristics of the embodiments. These omitted details include, among others, electrical connectors, electrical power supplies, gas or fluid supplies, fluid inlets and/or fluid outlets. Some characteristics of the embodiments may appear exaggerated to facilitate understanding.

Unless indicated otherwise, when reference is made to two elements connected together, this signifies a direct connection without any intermediate elements other than conductors, and when reference is made to two elements coupled together, this signifies that these two elements can be connected or they can be coupled via one or more other elements.

In the following disclosure, unless indicated otherwise, when reference is made to absolute positional qualifiers, such as the terms "front", "back", "top", "bottom", "left", "right", etc., or to relative positional qualifiers, such as the terms "above", "below", "higher", "lower", etc., or to qualifiers of orientation, such as "horizontal", "vertical", etc., reference is made to the orientation shown in the figures, or to an apparatus as orientated during normal use.

Unless specified otherwise, the expressions "around", "approximately", "substantially" and "in the order of" signify within 10 % or 10°, and preferably within 5 % or 5°.

The figures may not be to scale. It should be noted that the figures refer to embodiments of the deposition apparatus, when no ambiguity is anticipated. Other embodiments may be possible, as someone with appropriate training may readily appreciate. The actual dimension and/or shape of each of the elements of the embodiments may vary.

In the following disclosure, a substrate may have different shapes, for example in the form of a substrate tape or a tubular substrate. Other shapes may be encompassed by the person skilled in the art. There may be one or a plurality of substrates, having one or different shapes. In case of a plurality of substrates, the deposition surface, or first surface, correspond to the addition of the deposition surfaces of all the substrates.

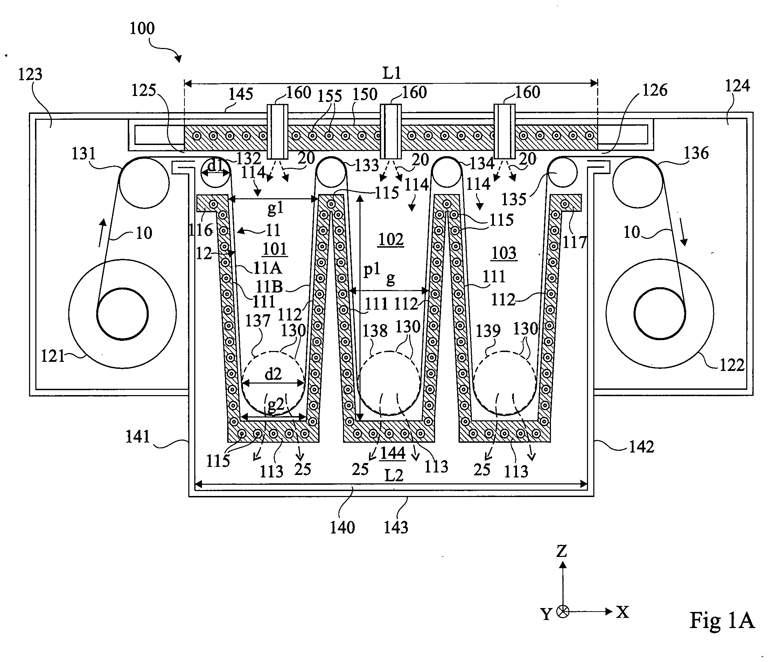

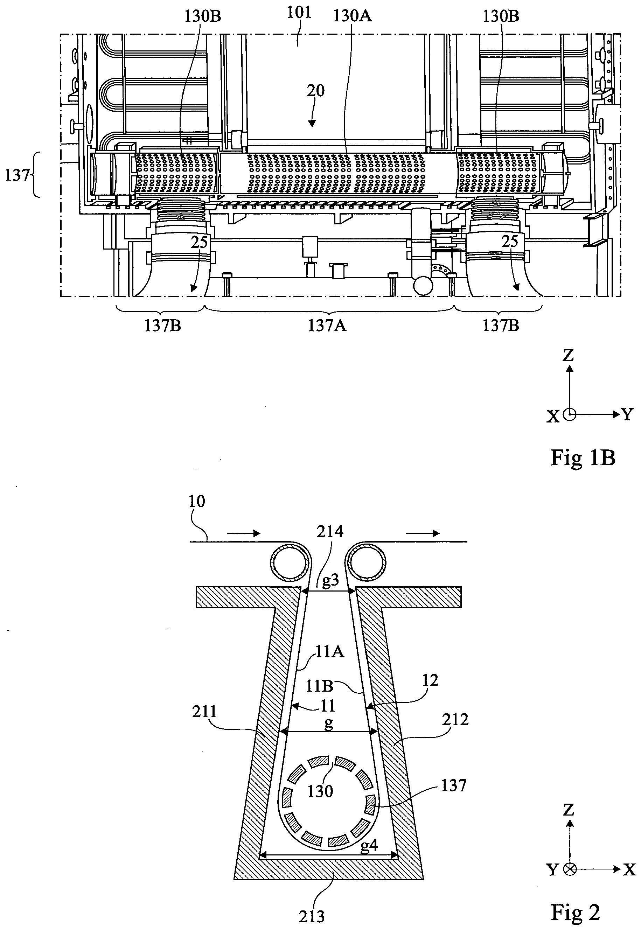

Figure 1A schematically illustrates, in a cross-section view, a deposition apparatus 100 according to an embodiment. Figure 1B schematically illustrates, in another cross-sectional view, a detail of the deposition apparatus of figure 1A.

The deposition apparatus 100 is adapted to form a high temperature superconductor (HTS) layer on a substrate 10, which is, in the example of Figure 1A, a substrate tape. The substrate tape 10 may be a flexible tape. For example, the substrate tape is a Hastelloy tape having a thickness of around 100 µm. For example, the substrate tape has a width, in the Y direction, comprised between 24 and 100 cm.

The substrate tape 10 comprises a deposition surface 11 (first surface), or front surface, on which the HTS layer is to be deposited, and a bottom surface 12 (front surface) opposite the deposition surface 11.

The deposition apparatus 100 comprises a plurality of deposition chambers 101, 102, 103 coupled to one another, so that the substrate tape 10 can move from one deposition chamber to another deposition chamber.

In the example of figure 1A, the deposition apparatus 100 comprises three deposition chambers, a first deposition chamber 101, a second deposition chamber 102 and a third deposition chamber 103, arranged one next to another one. In variants, the deposition chambers could be arranged in a different manner from the arrangement of Figure 1A. In variants, the deposition apparatus 100 could comprise only one deposition chamber, or two deposition chambers, or even more than three deposition chambers.

Each deposition chamber comprises, and is delimited by, a first side wall 111, a second side wall 112 and a bottom wall 113 joining the first and second side walls. Each deposition chamber has an open end 114 through which the substrate tape 10 can enter and leave the deposition chamber. In figure 1A, the open end 114 is a top end. The top end 114 faces the bottom wall 113 which forms a close bottom end (close end).

In the example of Figure 1A, each deposition chamber 101, 102, 103 have an approximately trapezoidal-prism shape which is slightly larger, in the X direction, at the upper end than at the lower end. In other words, the distance, or gap, g1 between the first and second side walls 111, 112 at the top end 114 is slightly higher than the distance, or gap, g2 between the first and second side walls 111, 112 at the bottom close end 113. In a variant, the deposition chambers may have a parallelepipedal shape, that is, the distance between the first and second side walls at the top end could be substantially equal to the distance between the first and second side walls at the bottom close end.

The average distance g, or average gap, between the side walls in each deposition chamber is preferably defined, or minimized, to form a substantially confined, or reduced, area between these side walls, and, as a result, between substrate tape(s), or between parts of a substrate tape. For example, the ratio g/p1 of the average distance g to the depth p1 of the deposition chamber is lower than 0.1, for example comprised between 0.02 and 0.1.

The depth p1 of each deposition chamber is for example equals to, or higher than, 100 cm, while the average gap g may vary from 2 to 10 cm providing the ratio g/p1 between said 0.02 and 0.1. The width, in the Y direction, of the deposition chamber is higher than the width of the substrate tape 10. For example, the width of each deposition chamber is higher than 25 cm, or higher than 50 cm, for example equal to around 100 cm.

The substrate tape 10 is guided by a first spool 121, also named pay-out spool, to enter in the deposition chambers, in particular in the first deposition chamber 101 and by a second spool 122, also named a take-up spool, to leave the deposition chambers, in particular the third deposition chamber 103. In other words, the substrate tape 10 is translated between the pay-out spool 121 and the take-up spool 122 through the deposition chambers. The pay-out spool 121 is located in a first side chamber 123, which is arranged next to the first deposition chamber 101, and communicates with the first deposition chamber via a first opening 125. The take-up spool 122 is located in a second side chamber 124, which is arranged next to the third deposition chamber 103, and which communicates with the third deposition chamber via a second opening 126.

The substrate tape 10 enters the first deposition chamber 101 through the first opening 125. The first opening 125 can be a slit having dimensions, at least the width, in the Y direction, and the height, adapted to the passage of the substrate tape 10. The substrate tape 10 leaves the third deposition chamber 103 through the second opening 126. The second opening 126 can be a slit having dimensions, at least the width, in the Y direction, and the height, adapted to the passage of the substrate tape 10. In other words, the first and second openings have preferably each a width which is higher than the width of the substrate tape 10, and a height which is higher than the thickness of the substrate tape 10. The first opening 125 is for example located over the deposition chambers, and at the top of the first side chamber 123. Similarly, the second opening 126 is for example located over the deposition chambers, and at the top of the second side chamber 124.

The first and second side chambers 123, 124 are for example under an overpressure with regard to the deposition chambers, for example an overpressure comprised between 0.5 and 2 mbar, for example of argon or nitrogen pressure. This overpressure aims at avoiding the penetration of a gas flow comprising HTS precursor material (described hereafter) in these side chambers. This overpressure may create an additional gas flow which may be pumped after flowing through the deposition chambers by a screw pump, together with the output gas flow described hereafter.

The substrate tape 10 is guided through the deposition chambers 101, 102, 103 via a set of guiding rollers located inside these side and deposition chambers.

In the example of figure 1A, the set of guiding rollers comprises a plurality of top guiding rollers:
- a first top guiding roller 131 located inside the first side chamber 123 near the first opening 125 in such a way to guide the substrate tape 10 from the first spool 121 towards the first opening 125;
- a second top guiding roller 132 located at the entry of the first deposition chamber 101 near the first opening 125 in such a way to guide the substrate tape 10 to enter the first deposition chamber 101;
- a third top guiding roller 133 located between the first deposition chamber 101 and the second deposition chamber 102 in such a way to guide the substrate tape 10 to leave the first deposition chamber 101 and enter the second deposition chamber 102;
- a fourth top guiding roller 134 located between the second deposition chamber 102 and the third deposition chamber 103 in such a way to guide the substrate tape 10 to leave the second deposition chamber 102 and enter the third deposition chamber 103;
- a fifth top guiding roller 135 located at the exit of the third deposition chamber 103 near the second opening 126 in such a way to guide the substrate tape 10 to leave the third deposition chamber 103 towards the second opening 126;
- a sixth top guiding roller 136 located inside the second side chamber 124 near the second opening 126 in such a way to guide the substrate tape 10 from the second opening 126 to the second spool 122.

In the example of figure 1A, the set of guiding rollers further comprises a plurality of bottom guiding rollers, one bottom guiding roller in each of the deposition chambers:
- a first bottom guiding roller 137 in the first deposition chamber 101 between the second top guiding roller 132 and the third top guiding roller 133;
- a second bottom guiding roller 138 in the second deposition chamber 102 between the third top guiding roller 133 and the fourth top guiding roller 134; and
- a third bottom guiding roller 139 in the third deposition chamber 103 between the fourth top guiding roller 134 and the fifth top guiding roller 135.

Each bottom guiding roller 137, 138, 139 is configured to guide the substrate tape 10 at the bottom of the deposition chamber in which it is located, in order the substrate tape 10 to follow the side walls 111, 112 and to come close to the bottom wall 113. Advantageously, each bottom guiding roller has a diameter d2 which is suited, or adjusted, to the gap g2 between the side walls 111, 112 at the bottom end of the deposition chamber in which it is located.

The substrate tape 10 may be provided with regularly spaced perforations, for example at one of the side edges of the substrate tape (not shown). In an example, the translation of the substrate tape can be controlled by controlling a pulsed signal that is triggered by a light transmission through a set of regular openings provided near, for example at a distance of one centimeter, the perforations at the side edges of the substrate tape. In another example, the translation of the substrate tape can be controlled using the regularly spaced perforations for synchronizing the rotation of at least one of the guiding rollers, for example at least one of the bottom guiding rollers, with the substrate translation. For example, an additional gear may be installed in an edge portion of at least one of the bottom guiding rollers to couple this bottom guiding roller to the regularly spaced perforations of the substrate tape.

Each bottom guiding roller 137, 138, 139 comprises a plurality of through-holes 130 which can be used for a passage of gas flow as explained below. In other words, each bottom guiding roller is perforated, forming a guiding roller that is permeable to the gas flow.

An input gas flow 20 containing an HTS precursor material in vapor phase can be delivered inside each deposition chamber through precursor inlets 160, such as nozzles. The HTS precursor material is used in the deposition chambers 101, 102, 103 to deposit the HTS layer on the deposition surface 11 of the substrate tape 10.

In an embodiment, the HTS precursor material comprises a tetrahydrofuran (THF) organic precursor. The input gas may comprise a carrying gas, such as argon or nitrogen, for carrying the HTS precursor material. In some non-limiting examples, the HTS precursor material may comprise Y-THF, Ba-THF and Cu-THF precursors, possibly with a reactive oxygen gas in addition to the carrying gas. In a particular example, the final composition of the HTS layer corresponds to YBa₂Cu₃O₇₋ₓ compound. Yttrium (Y) can be replaced by another rare earth element, such as La, Nd, Sm, Eu, Gd, Sc, Tb, Dy, Ho, Er, Tm, Yb or Lu, and the precursor material may be adapted accordingly. In some embodiments, the HTS precursor material may comprise a doping precursor, such as a barium zirconate, which may improve the performance of the HTS layer, for example in high magnetic field, or even ultra-high magnetic field, for example above 30 Teslas (T).

As illustrated in Figure 1B that illustrates details of bottom guiding roller 137 in the Y direction (whereas Figure 1A shows the X direction), at least a part of the input gas flow 20 penetrates in a central portion 137A of the bottom guiding roller 137 through central through-holes 130A, and an output gas flow 25 escapes from the interior of the bottom guiding roller 137 in peripherical portions 137B through peripherical through-holes 130B. Figure 1B shows details of bottom guiding roller 137, but these details can apply to the other bottom guiding rollers 138, 139. The output gas is then removed from the deposition apparatus 100, for example via pumps, such as screw pumps (not shown).

For example, the input gas flow 20 may have a flow rate comprised between to 50-300 standard liters per minute (slm). For example, the gas pressure in the deposition chambers may be comprised between 2 and 4 mbar.

The deposition chambers 101, 102, 103 may be contained in a housing 140, which may be named a reactor, having a closed bottom end. The housing 140 comprises first and second side walls 141, 142 which have common parts with the side chambers 123, 125 and a bottom wall 143 joining the first and second side walls 141, 142. The first opening 125, respectively the second opening 126, may be formed in the first side wall 141, respectively the second side wall 142, of the housing 140, at a top portion of these side walls. A closed chamber 144 is defined between the side and bottom walls 111, 112, 113 of the deposition chambers 101, 102, 103 and the side and bottom walls 141, 142, 143 of the housing 140. A first horizontal wall 116 may connect a top end of the first side wall 111 of the first deposition chamber 101 to the first side wall 141 of the housing 140. Similarly, a second horizontal wall 117 may connect a top end of the second side wall 112 of the third deposition chamber 103 to the second side wall 142 of the housing 140. It is noted that the top end of the second side wall 112 of the first deposition chamber 101 joins the top end of the first side wall 111 of the second deposition chamber 102, and similarly that the top end of the second side wall 112 of the second deposition chamber 102 joins the top end of the first side wall 111 of the third deposition chamber 103.

The closed chamber 144 may be coupled to a pump (not shown) or other means adapted to form a vacuum, for example a high vacuum, for example lower than 10⁻⁴ mbar, or between 10⁻⁴ and 10⁻⁶ mbar, in this closed volume. Pumping down the closed chamber 144 under the deposition chambers 101, 102, 103 to a high vacuum (typically with a pressure below 10⁻⁴ mbar) may have an advantage of improving the thermal insulation of these deposition chambers.

In one embodiment, the faces of the side and bottom walls 111, 112, 113 which are in front of the closed chamber 144 may comprise an infrared (IR) shielding (not shown), for example a plurality (typically 10 to 40 layers) of sheets of infrared shielding. That improves the thermal insulation of the deposition chambers, by suppressing the IR losses.

The housing 140 may comprise a top wall 145 which may close the housing 140, except at the first and second openings 125, 126 which open the housing 140 to the side chambers 123, 124. The top wall 145 of the housing 140 may be prolongated by, or be common with, the top walls of the side chambers 123, 124.

The deposition chambers 101, 102, 103 are adapted to be heated using a heating system. The heating system advantageously provides a thermal heating source which may be distributed, for example homogeneously distributed, over the width, as well as the length, of the substrate tape 10. The thermal heating source may advantageously follow the shape of the substrate tape 10 in each deposition chamber. The thermal heating source may advantageously have no direct thermal conductive contacts with the substrate tape 10. A minimal distance, typically of about 0.5 to 10 mm, may be provided between the thermal heating source and the substrate tape in each deposition chamber.

In the example of Figure 1A, the heating system comprises a plurality of heating elements, such as heating wires 115, which are embedded in the side and bottom walls 111, 112, 113 of the deposition chambers. Therefore, the side and bottom walls 111, 112, 113 may form heating walls. The heating wires 115 may be homogeneously distributed in the side and bottom walls 111, 112, 113, in particular in the longitudinal direction of each wall and in the Y direction (width direction of each wall).

When the substrate tape 10 moves along the side and bottom walls 111, 112, 113 of the deposition chambers 101, 102, 103, the substrate tape 10 is heated by the embedded heating wires 115 and the walls 111, 112 and 113 which are heated by the wires 115. The heating of the substrate tape 10 is performed by infrared (IR) radiation emitted by the embedded heating wires 115 and heated walls 111, 112 and 113. The radiation is absorbed by the bottom surface 12 of the substrate tape 10, opposite the deposition surface 11.

More generally, the substrate tape, or substrate, is preferably heated from a surface which is opposite to the surface aimed for HTS layer deposition.

With the heating wires 115 embedded in the side and bottom walls 111, 112, 113, the thermal heating source can follow the shape of the substrate tape 10 in the deposition chambers.

With the heating wires 115 embedded in the side and bottom walls 111, 112, 113, the thermal heating source can have no direct thermal conductive contacts with the substrate tape 10.

The deposition apparatus 100 may further comprise a cover wall 150 over the deposition chambers 101, 102, 103, for example between the top wall 145 of the housing 140 and the deposition chambers 101, 102, 103. For example, the cover wall 150 is in contact with the top wall 145. The cover wall 150 has a length L1 in the X direction which may be substantially equal to the length L2 in the X direction of the housing 140. The cover wall 150 may function as a shielding of the deposition chambers 101, 102, 103. The cover wall 150 may be heated, for example may incorporate heating wires 155, which may be similar to the heating wires 115. The temperature at the cover wall 150 (second temperature) is preferably lower than the temperature in the deposition chambers 101, 102, 103 (first temperature). For example, the first temperature can reach 850°C, or even 900°C, and the second temperature is generally around 500°C or less. An advantage of the heating at the cover wall 150 is to reduce,• or even suppress, HTS deposition on and/or around the cover wall 150, and thus to reduce losses of deposition material.

The precursor inlets 160 may go through the top wall 145 of the housing 140 and the cover wall 150, and end in the deposition chambers 101, 102, 103.

In operation, the substrate tape 10 enters the first deposition chamber 101 through the first opening 125 around the second top guiding roller 132 and translates along the first side wall 111 down to the first bottom guiding roller 137. Then, the substrate tape 10 rolls around the first bottom guiding roller 137 along the first side wall 111, the bottom wall 113, and the second side wall 112. Then, the substrate tape 10 goes up to the third top guiding roller 133 along the second side wall 112, and enters the second deposition chamber 102 around the third top guiding roller 133. The translation of the substrate tape 10 in the second deposition chamber 102, to the third deposition chamber 103, and in the third deposition chamber 103 is similar to what is described for the first deposition chamber 101. The substrate tape 10 is guided outside the third deposition chamber 103 through the second opening 126 around the fifth top guiding roller 135. During the translation of the substrate tape 10, the input gas flow 20 containing the HTS precursor material is introduced in the deposition chambers, the gas flow being able to circulate through the perforated bottom guiding rollers 137, 138, 139, so that the output gas flow 25 can escape from the interior of the bottom guiding rollers. The second surface 12 of the substrate tape 10 is heated and the deposition surface 11 is coated with the HTS material.

The translation of the substrate 10 in each deposition chamber 101, 102, 103 is performed along the side walls 111, 112 in such a way that, during this translation, a first part 11A of the deposition surface 11 (along the first side wall 111) faces a second part 11B of the deposition surface 11 (along the second side wall 112). Since the average gap g between the side walls is reduced compared to the depth, and the width in the Y direction, of each deposition chamber, forming a substantially reduced area between these side walls, IR emissions from the first part 11A can be confined by the second part 11B, conversely IR emissions from the second part 11B can be confined by the first part 11A. In other words, IR emissions can be confined in the reduced and almost closed area, heat losses can be reduced, and the temperature can be more uniformly distributed along the width, and the length, of the substrate tape than in the conventional deposition apparatuses. According to the embodiments, the heat losses can represent about only 5% of the losses in the conventional deposition apparatuses.

The reduced area between the side walls may be a vacuum-tight area. In addition, having heating elements embedded in the side walls may form a thermally confined reduced area, as a semi-closed area, between the side walls.

Figure 2 schematically illustrates, in a cross-sectional view, a variant of the deposition apparatus of figure 1A.

In the variant of Figure 2, the deposition chamber 201 differs from the deposition chamber 101 of Figure 1A in that the distance, or gap, g3 between the first and second side walls 211, 212 at the open end 214 (top end) is lower than the distance, or gap, g4 between the first and second side walls at the closed end, that is, at the bottom wall 213. As for the deposition chamber 101 of Figure 1A, the average distance g is for example lower than 4 centimeters (cm), for example comprised between 2 and 4 cm.

An advantage of the variant of Figure 2 is that it may further reduce IR heat losses.

Compared to the variant of Figure 2, the embodiment of Figure 1A can have a higher deposition rate and also a higher material yield.

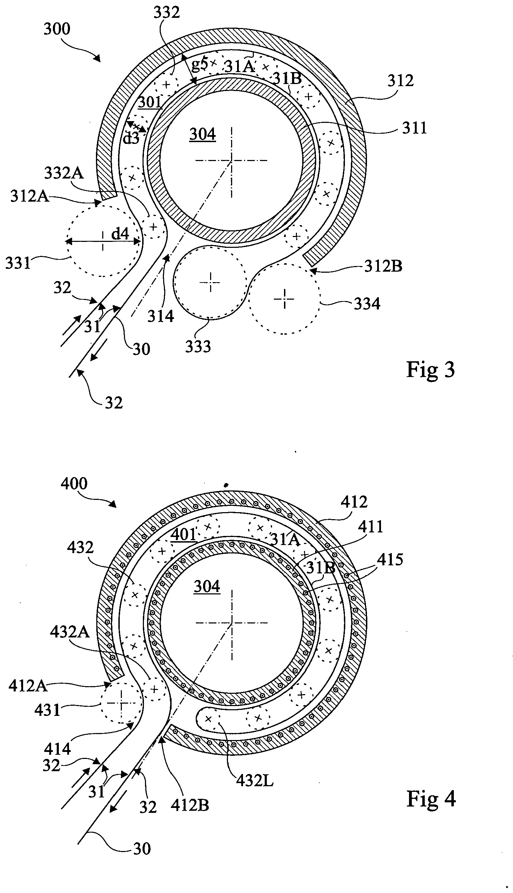

Figure 3 schematically illustrates, in a cross-section view, a deposition apparatus 300 according to another embodiment.

In the embodiment of Figure 3, the deposition apparatus 300 comprises a deposition chamber 301 which comprises, and is delimited by, an inner side wall 311 (first side wall) and an outer side wall 312 (second side wall) around the inner side wall 311. The inner and the outer walls 311, 312 are substantially cylindrical, or tubular. The inner and outer side walls may be coaxial.

In other words, instead of having an approximately trapezoidal-prism shape or parallelepipedal shape, the deposition chamber 301 has an annular shape, or ring shape, delimited by the inner side wall 311 and the outer side wall 312.

The outer side wall 312 comprises an opening 314 adapted to the inlet and the outlet of a substrate tape 30 having a deposition surface 31 (first surface) on which the HTS layer is to be deposited, and a second surface 32 opposite the first surface. The opening 314 is formed between a first end 312A and a second end 312B of the outer side wall 312.

The substrate tape 30 is guided through the deposition chamber 301 via a set of guiding rollers located inside and outside the deposition chamber 301. The substrate tape 30 can translate along one of the inner and outer side walls on the way out and along the other one of the inner and outer side walls on the way back. In the example of Figure 3, the substrate tape 30 translates along the outer side wall 312 after entering the deposition chamber 301 and translates back along the inner side wall 311 before leaving the deposition chamber 301. An outer guiding roller 333 may guide the substrate tape 30 from the forward path to the return path.

In the example of Figure 3, the set of guiding rollers comprises:
- a first outside guiding roller 331 located outside the deposition chamber 301 near the opening 314 in such a way to guide the substrate tape 30 inside the deposition chamber 301;
- a plurality of inside guiding rollers 332 located inside the deposition chamber 301, between the inner side wall 311 and the outer side wall 312, and adapted to guide the substrate tape 30 along the outer side wall 312 on the way out and along the inner side wall 311 on the way back;
- a second outside guiding roller 333 located outside the deposition chamber 301 near the opening 314 in such a way to guide the substrate tape 30 from the forward path to the return path; and, possibly
- a third outside guiding roller 334 located outside the deposition chamber 301 near the second outside guiding roller 333 in such a way to guide the substrate tape 30 to roll around the second outside guiding roller 333.

A first inside guiding roller 332A of the inside guiding rollers 332 may be adapted to manage, together with the first outside guiding roller 331, the inlet and the outlet of the substrate tape 30.

The inside guiding rollers 332 have a diameter d3 which is lower than the distance g5 between the inner side wall 311 and the outer side wall 312. The diameter d3 and the distance g5 are preferably defined so that the substrate tape 30 can pass between the inner side wall 311 and the inside guiding rollers 332 and between the outer side wall 312 and the inside guiding rollers 332.

The outside guiding rollers 331, 333, 334 have a diameter d4 which is for example higher than the diameter d3 of the inside guiding rollers 332.

The guiding rollers of Figure 3 are preferably perforated, for example the guiding rollers comprise through-holes similar to the through-holes 130 of the bottom guiding rollers of Figure 1A, suitable for the passage of a gas flow.

The deposition chamber 301 is heated-using a heating system. The heating system may comprise a plurality of heating wires embedded in the inner and outer side walls 311, 312 of the deposition chamber 301, similarly to the heating wires 115 of Figure 1A, and to the heating wires 415 represented in Figure 4 described hereafter. Therefore, the inner and outer side walls 311, 312 may form heating walls. The heating wires may be homogeneously distributed in the inner and outer side walls. With the embedded heating wires, the substrate tape 30 is adapted to be heated by infrared radiation emitted by the embedded heating wires towards the second surface 32 of the substrate tape, opposite the deposition surface 31.

In operation, the substrate tape 30 enters the deposition chamber 301 between the first outside guiding roller 331 and the first inside guiding roller 332A and translates along the outer side wall 312. In the forward path, the substrate tape 30 translates between the outer side wall 312 and the inner guiding rollers 332. Then the substrate tape 30 is guided by the second outside guiding roller 333 from the forward path to the return path. In the return path, the substrate tape 30 translates between the inner side wall 311 and the inner guiding rollers 332. Then the substrate tape 30 leaves the deposition chamber 301 guided by the first inside guiding roller 332A. An input gas flow containing an HTS precursor material in vapor phase is introduced in the deposition chamber 301, the gas flow being able to circulate through the perforated guiding rollers. All along the forward path and the return path, the second surface 32 of the substrate tape 30 is heated and the deposition surface 31 of the substrate tape 30 is coated with the HTS material.

When the substrate tape 30 translates through the deposition chamber 301, a first part 31A of the deposition surface 31 of the substrate tape 30 is on the way out and is along the outer side wall 312, while a second part 31B of the deposition surface 31 of the substrate tape 30 in on the way back and along the inner side wall 311. The inner guiding rollers 332 are located between the first part 31A and the second part 31B.

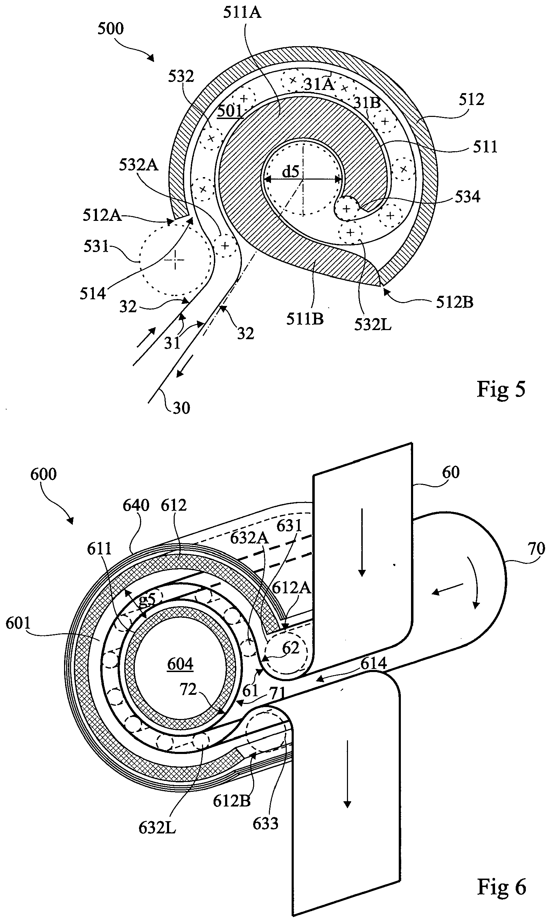

The translation of the substrate 30 is performed in the deposition chamber 301 in such a way that, during the translation, the first part 31A of the deposition surface 31 faces the second part 31B of the deposition surface 31. Since the gap g5 between the inner and outer side walls 311, 312 is reduced compared to the depth, and the width, of the deposition chamber 301, the distance between the first part 31A and the second part 31B of the deposition surface 31 is reduced, forming a substantially reduced area between these first and second parts. Thus, IR emissions from the first part 31A can be confined by the second part 31B, conversely IR emissions from the second part 31B can be confined by the first part 31A. In other words, IR emissions can be confined in the reduced area, heat losses can be reduced, and the temperature can be more uniform along the width, and the length, of the substrate tape than in the conventional deposition apparatuses. These technical effects and advantages can also apply to the embodiments described hereafter in relation with Figures 4 and 5.

Figure 4 schematically illustrates, in a cross-section view, a deposition apparatus 400 according to a variant of the deposition apparatus of Figure 3.

Similarly to the embodiment of Figure 3, the deposition apparatus 400 of Figure 4 comprises a deposition chamber 401 which comprises, and is delimited by, an inner side wall 411 (first side wall) and an outer side wall 412 (second side wall). An opening 414 adapted to the inlet and the outlet of a substrate tape 30 is formed in the outer side wall 412, between a first end 412A and a second end 412B of the outer side wall 412. The inner and the outer walls 411, 412 are substantially cylindrical, or tubular. The inner and outer side walls may be coaxial.

The deposition apparatus 400 of Figure 4 differs from that of Figure 3 mainly in that the substrate tape 30 is guided from the forward path to the return path inside the deposition chamber 401, using a last inside guiding roller 432L of the inside guiding rollers 432. There is no use for the second and third outside guiding rollers 333, 334 of Figure 3. The set of guiding rollers may further comprise an outside guiding roller 431 located outside the deposition chamber 401 near the opening 414 in such a way to guide the substrate tape 30 inside the deposition chamber 401. The outside guiding roller 431 may be similar to, or may be smaller than, the first outside guiding roller 331 of Figure 3.

A first inside guiding roller 432A of the inside guiding rollers 432 may be adapted to manage, together with the first outside guiding roller 431, the inlet and the outlet of the substrate tape 30.

The opening 414 in the outer side wall 412 may be smaller than the opening 314 in the outer side wall 312 of Figure 3.

Similarly to Figure 3, the guiding rollers of Figure 4 are preferably perforated, for example the guiding rollers comprise through-holes similar to the through-holes 130 of the bottom guiding rollers of Figure 1A, suitable for the passage of a gas flow.

The deposition chamber 401 can be heated using a heating system. As represented in Figure 4, the heating system may comprise a plurality of heating wires 415, for example similar to the heating wires 115 of Figure 1A, which are embedded in the inner and outer side walls 411, 412 of the deposition chamber. Therefore, the inner and outer side walls may form heating walls. The heating wires 415 may be homogeneously distributed in the inner and outer side walls 411, 412. With the embedded heating wires, the substrate tape 30 is adapted to be heated by infrared radiation emitted by the embedded heating wires towards the second surface 32 of the substrate tape, opposite the deposition surface 31.

In operation, the substrate tape 30 enters the deposition chamber 401 through the opening 414, between the first outside guiding roller 431 and the first inside guiding roller 432A and translates along the outer side wall 412. In the forward path, the substrate tape 30 translates between the outer side wall 412 and the inner guiding rollers 432. Then the substrate tape 30 is guided by the last inside guiding roller 432L from the forward path to the return path. In the return path, the substrate tape 30 translates between the inner side wall 411 and the inner guiding rollers 432. Then the substrate tape 30 leaves the deposition chamber 401 through the opening 414, guided by the first inside guiding roller 432A. An input gas flow containing an HTS precursor material in vapor phase is introduced in the deposition chamber 401, the gas flow being able to circulate through the perforated guiding rollers. All along the forward path and the return path, the second surface 32 of the substrate tape 30 is heated and the deposition surface 31 is coated with the HTS material.

The translation of the substrate 30 is performed in the deposition chamber 401 in such a way that, during the translation, a first part 31A of the deposition surface 31 faces a second part 31B of the deposition surface 31.

In the embodiments of Figures 3 and 4, a closed chamber 304 is formed inside the inner side wall 311, 411. As for the closed chamber 144 of Figure 1A, the closed chamber 304 may be coupled to a pump (not shown) or other means adapted to form a vacuum, or a high vacuum, for example between 10⁻⁴ and 10⁻⁶ mbar, in this closed volume. Pumping down the closed chamber 304 to a high vacuum (typically with a pressure below 10⁻⁴ mbar) may have an advantage of improving the thermal insulation of the deposition chamber 301, 401.

Figure 5 schematically illustrates, in a cross-section view, a deposition apparatus 500 according to another variant of the deposition apparatus of Figure 3.

Similarly to the embodiment of Figure 3, the deposition apparatus 500 of Figure 5 comprises a deposition chamber 501 which comprises, and is delimited by, an inner side wall 511 (first side wall) and an outer side wall 512 (second side wall). The outer side wall 512 is opened between a first end 512A and a second end 512B of that outer side wall. The outer wall 312 is partially tubular.

The deposition apparatus 500 of Figure 5 differs from the deposition apparatus 300 of Figure 3 mainly in that the inner side wall 511 has a first part 511A which is circular and a second part 511B substantially straight prolongating the first part 511A and joining the second end 512B of the outer side wall 512. Thus, the deposition chamber 501 has a spiral shape instead of an annular shape. The inner side wall 511 does not form a closed chamber, the volume inside the inner side wall 511 being coupled to the volume comprised between the inner side wall 511 and the outer side wall 512, forming the volume of the deposition chamber 501. The opening 514 for the inlet and the outlet of a substrate tape 30 is positioned between the first end 512A of the outer side wall 512 and the second part 511B of the inner side wall 511.

In addition, the substrate tape 30 is guided from the forward path to the return path inside the inner side wall 511, more precisely around a central guiding roller 533 positioned inside the first part 511A of the inner side wall 511. The central guiding roller 533 may have an axis which substantially coincides with the axis of the inner side wall 511, and/or with the axis of the outer side wall 512. The central guiding roller 533 has a diameter d5 which is smaller than the inner diameter of the first part 511A of the inner side wall 511.

The set of guiding rollers may further include an outside guiding roller 531, which may be similar to the first outside guiding roller 331 of Figure 3, located outside the deposition chamber 501 near the opening 514 in such a way to guide the substrate tape 30 inside the deposition chamber 501.

Similarly to the embodiment of Figure 3, the set of guiding rollers includes inside guiding rollers 532 between the inner side wall 511 and the outer side wall 512, and a first inside guiding roller 532A of the inside guiding rollers 532 may be adapted to manage, together with the first outside guiding roller 531, the inlet and the outlet of the substrate tape 30.

Similarly to Figure 3, the guiding rollers of Figure 5 are preferably perforated, for example the guiding rollers comprise through-holes similar to the through-holes 130 of the bottom guiding rollers of Figure 1A, suitable for the passage of a gas flow.

Similarly to the heating wires 415 of Figure 4, the deposition chamber 501 may be heated using a plurality of heating wires embedded in the inner and outer side walls 511, 512. The heating wires may be homogeneously distributed in the inner and outer side walls. With the embedded heating wires, the substrate tape 30 is adapted to be heated by infrared radiation emitted by the embedded heating wires towards the second surface 32 of the substrate tape, opposite the deposition surface 31.

In operation, the substrate tape 30 enters the deposition chamber 501 through the opening 514 by rolling between the first outside guiding roller 531 and the first inside guiding roller 532A, and then translates along the outer side wall 512. In the forward path, the substrate tape 30 translates between the outer side wall 512 and the inner guiding rollers 532. Then the substrate tape 30 is guided inside the first part 511A of the inner side wall 511 and turns around the central guiding roller 533 which guides the substrate tape 30 from the forward path to the return path. An intermediate guiding roller 534 may be positioned near the central guiding roller 533, the substrate tape 30 passing between this intermediate guiding roller 534 and the central guiding roller 533. In the return path, the substrate tape 30 translates between the inner side wall 511 and the inner guiding rollers 532. The substrate tape 30 leaves the deposition chamber 501 guided by the first inside guiding roller 532A. An input gas flow containing an HTS precursor material in vapor phase is introduced in the deposition chamber 501, the gas flow being able to circulate through the perforated guiding rollers. All along the forward path and the return path, the second surface 32 of the substrate tape 30 is heated and the deposition surface 31 is coated with an HTS material.

The translation of the substrate 30 is performed in the deposition chamber 501 in such a way that, during the translation, a first part 31A of the deposition surface 31 faces a second part 31B of the deposition surface 31.

In the examples described in relation with Figures 3 to 5, the substrate tape 30 is adapted to follow a particular path in the deposition chamber. Alternatively, the substrate tape could follow other paths, for example could circulate in the opposite direction, that is, the forward path would become the return path and the return path would become the forward path.

Figure 6 schematically illustrates, in a cross-section view, a deposition apparatus 600 according to another embodiment.

Similarly to the embodiment of Figure 3, the deposition apparatus 600 of Figure 6 comprises a deposition chamber 601 which comprises, and is delimited by, an inner side wall 611 (first side wall) and an outer side wall 612 (second side wall). An opening 614 adapted to the inlet and the outlet of a substrate tape 60 is formed in the outer side wall 612, between a first end 612A and a second end 612B of the outer side wall 612. The substrate tape 60 has a deposition surface 61 (first surface) on which the HTS layer is to be deposited, and a second surface 62 opposite the deposition surface 61.

Similarly to the embodiment of Figure 3, the substrate tape 60 is guided through the deposition chamber 601 along the outer side wall 612 via a set of guiding rollers located inside and outside the deposition chamber 601, the set of guiding rollers comprising:
- a first outside guiding roller 631 located outside the deposition chamber 601 near the opening 614 in such a way to guide the substrate tape 60 inside the deposition chamber 601;
- a plurality of inside guiding rollers 632 located inside the deposition chamber 601, between the inner side wall 611 and the outer side wall 612, and adapted to guide the substrate tape 60 along the outer side wall 612;
- a second outside guiding roller 633 located outside the deposition chamber 601 near the opening 614 in such a way to guide the substrate tape 60 outside the deposition chamber 601.

Similarly to Figure 3, the guiding rollers of Figure 6 are preferably perforated, for example the guiding rollers comprise through-holes similar to the through-holes 130 of the bottom guiding rollers of Figure 1A, suitable for the passage of a gas flow.

The deposition apparatus 600 of Figure 6 differs from the deposition apparatus 300 of Figure 3 mainly in that the substrate tape 60 does not return back in the deposition chamber 601 along the inner side wall 611, and that the substrate tape 60 is around another substrate, which is a tubular substrate 70 having a deposition surface 71 (first surface), or outer surface, on which the HTS layer is to be deposited, and a second surface 72, or inner surface, opposite the deposition surface 71. In the deposition chamber 601, the deposition surface 71 of the tubular substrate 70 is arranged to face the deposition surface 61 of the substrate tape 60, the inside guiding rollers 632 being positioned between the deposition surface 71 of the tubular substrate 70 and the deposition surface 61 of the substrate tape 60.

The substrate tape 60 and the tubular substrate 70 form a plurality of substrates. The deposition surfaces 61, 71 of the substrate tape 60 and of the tubular substrate 70 form a deposition surface of the plurality of substrates, the deposition surface 61 of the substrate tape 60 representing a first part of the deposition surface of the plurality of substrates, and the deposition surface 71 of the tubular substrate 70 representing a second part of the deposition surface of the plurality of substrates.

Similarly to the heating wires 415 of Figure 4, the deposition chamber 601 may be heated using a plurality of heating wires embedded in the inner and outer side walls 611, 612. The heating wires may be homogeneously distributed in the inner and outer side walls. With the embedded heating wires, each of the substrate tape 60 and the tubular substrate 70 can be heated by infrared radiation emitted by the embedded heating wires towards the second surface 62, 72, opposite the deposition surface 61, 71.

Similarly to the deposition apparatus 100 of Figure 1A, the rotation of the guiding rollers of Figure 6 with the motion of the substrate tape 60 may be established via perforations introduced near, or at, one of the side edges of the substrate tape 60 configured to be coupled with an additional gear (not shown) installed on at least one of the guiding rollers. This can also apply to the embodiments of Figures 3, 4, 5.

In operation, the substrate tape 60 enters the deposition chamber 601 between the first outside guiding roller 631 and the first inside guiding roller 632A, and is translated along the outer side wall 612, while the tubular substrate 70 rolls around the inner side wall 611 and translates in the direction of the width of the substrate tape 60, which is also the axial direction of the tubular substrate 70. The substrate tape 60 leaves the deposition chamber 601 guided by the second outside guiding roller 633. An input gas flow containing an HTS precursor material in vapor phase is introduced in the deposition chamber 601, the gas flow being able to circulate through the perforated guiding rollers. The second surface 62 of the substrate tape 60 is heated, preferably by the heating wires embedded in the outer side wall 612, and the second surface 72 of the tubular substrate 70 is heated preferably by the heating wires embedded in the inner side wall 611, and the deposition surfaces 61, 71 of the substrate tape 60 and the tubular substrate 70 are coated with the HTS material.

The translation of the substrate assembly in the deposition chamber 601 is performed in such a way that, during the translation, the deposition surface 61 of the substrate tape 60 faces the deposition surface 71 of the tubular substrate 70. Since the gap g5 between the inner and outer side walls 611, 612 is reduced compared to the depth, and the width, of the deposition chamber 601, the distance between the deposition surface 61 of the substrate tape 60 and the deposition surface 71 of the tubular substrate 70 is reduced, forming a substantially reduced area between these deposition surfaces. Thus, IR emissions from the deposition surface 61 can be confined by the deposition surface 71, conversely IR emissions from the deposition surface 71 can be confined by the deposition surface 61. In other words, IR emissions can be confined in the reduced area, heat losses can be reduced, and the temperature can be more uniform along the width, and the length, of the substrate tape than in the conventional deposition apparatuses.

The gas flow is preferably introduced into a gap between the substrate tape 60 and the tubular substrate 70. Different directions of the gas flow, for example parallel to the axial direction and/or around a circumference of the tubular surface can be employed.

Similarly to the embodiments of Figures 3 and 4, a closed chamber 604 may be formed inside the inner side wall 611. As for the closed chamber 144 of Figure 1A, the closed chamber 604 may be coupled to a pump (not shown) or other means adapted to form a vacuum, or a high vacuum, for example between 10⁻⁴ and 10⁻⁶ mbar, in this closed volume. Pumping down the closed chamber 604 to a high vacuum (typically with a pressure below 10⁻⁴ mbar) may have an advantage of improving the thermal insulation of the deposition chamber 601.

The deposition apparatus 600 of Figure 6 may further comprise at least an infrared shield (IR shield) 640, or a stack of IR shields, around the outer side wall 612. Such IR shield(s) may contribute to suppress IR emissions outside the deposition chamber 601, and thus, to reduce heat losses.

The embodiment of Figure 6 enables a significant reduction of heat losses as well as unexpectedly high improvement, for example to around 85%, of the material yield.

The precursor inlet and other details are not represented in Figures 3 to 6, but the person skilled in the art will be able to integrate such details in the embodiments, of Figures 3 to 6, for example using the details given in relation with Figures 1A and 1B.

As a non-limiting example which can apply to each of the embodiments of Figures 3 to 6, the distance g5 between the inner side wall and the outer side wall may be lower than 8 cm, for example comprised between 2 and 8 cm. This corresponds to the aspect ratio (AR) of about 8cm/100cm, that is, 0.08 as a maximal value while more common case yields the AR of about 5cm/100cm, that is 0.05.

In all the embodiments described above, having relatively small distances, for example lower than 8 cm, or lower than 6 cm, or between 2 and 4 cm, between the side walls, and thus between the first and second parts of the deposition surface in each deposition chamber, which is relatively large, and in some cases further having an infrared shielding, highly contributes to lower the IR heat losses, for example to around 5 kW for one meter wide substrate, compared to around 100-200 kW losses occurring in conventional deposition apparatuses for a one meter wide substrate. This creates a significant benefit not only regarding energy saving but also because a very complicated and expensive technique which would be needed to remove such heat power.

As an unexpected benefit of the embodiments, the inventors found a drastic increase of material yield during HTS layer deposition, for example a material yield increase from around 20% for a conventional deposition apparatus to around 50%, or even 80-90%, for a deposition apparatus according to the embodiments. This benefit finally results in reduced processing costs and suppression of contamination of the environment.

The description provided herein discloses examples of embodiments pertinent to high throughput deposition on a substrate, in particular of deposition of a high temperature superconductor (HTS) material on a substrate.

The embodiments can find applications in:
- fusion energy technologies, for example for superconductor components in stellarators or other devices used in fusion energy technologies;
- electromagnetic shielding, for example for shielding large volumes;
- levitation, used for example in transportation techniques, based on magnetic interaction;
- inductive fault current limiters, for example high power inductive fault current limiters and power switches, such as those based on large area tapes or cylinders.

Various embodiments and variants have been described. Those skilled in the art will understand that certain features of these embodiments can be combined and other variants will readily occur to those skilled in the art.

Finally, the practical implementation of the embodiments and variants described herein is within the capabilities of those skilled in the art based on the functional description provided hereinabove.

## Claims

1. A deposition apparatus (100; 300; 400; 500; 600) for depositing a high temperature superconductor (HTS) material onto a first surface (11; 31; 61, 71) of at least one substrate (10; 30; 60, 70), the deposition apparatus comprising:
- a deposition chamber (101; 201; 301; 401; 501; 601) comprising side walls (111, 112; 211, 212; 311, 312; 411, 412; 511, 512; 611, 612);
- a substrate transport system for transporting the at least one substrate in the deposition chamber along the side walls;
- a heating system for heating the at least one substrate in the deposition chamber at a first temperature;
- a precursor inlet (160) for delivering a gas flow (20) including an HTS material precursor into the deposition chamber;
wherein the side walls of the deposition chamber are arranged in such a way that, when the at least one substrate is transported along the side walls of the deposition chamber, a first part (11A; 31A; 61) of the first surface faces a second part (11B; 31B; 71) of the first surface.

2. A method for depositing a high temperature superconductor (HTS) material onto a first surface (11; 31; 61, 71) of at least one substrate (10; 30; 60, 70), the method comprising:
- transporting the at least one substrate in a deposition chamber (101; 201; 301; 401; 501; 601), along side walls (111, 112; 211, 212; 311, 312; 411, 412; 511, 512; 611, 612) of said deposition chamber, using a substrate transport system;
- heating the at least one substrate in the deposition chamber at a first temperature, using a heating system;
- delivering a gas flow including an HTS material precursor into the deposition chamber, using a precursor inlet (160);
wherein the transport of the at least one substrate is performed in the deposition chamber in such a way that an infrared emission between both first (11A; 31A; 61) and second (11B; 31B; 71) parts of the first surface is confined between said first and second parts.

3. The deposition apparatus according to claim 1, or the method according to claim 2, wherein the heating system is adapted to heat a second surface of the at least one substrate different from the first surface, for example a second surface opposite the first surface.

4. The deposition apparatus according to claim 1 or 3, or the method according to claim 2 or 3, wherein the heating system comprises a thermal heating source adapted to heat the at least one substrate via an infrared radiation, for example the thermal heating source:
- is distributed over the width of each of the at least one substrate; and/or
- has no direct thermal conductive contact with each of the at least one substrate; and/or
- is configured to follow the shape of the at least one substrate-in the deposition chamber.

5. The deposition apparatus according to any of claims 1, 3, 4, or the method according to any of claims 2 to 4, wherein the heating system comprises heating elements (115; 415), for example heating wires, integrated into the side walls, the side walls forming heating walls.

6. The deposition apparatus according to any of claims 1, 3 to 5, or the method according to any of claims 2 to 5, wherein the at least one substrate comprises a substrate tape (10; 30; 60).

7. The deposition apparatus according to any of claims 1, 3 to 6, or the method according to any of claims 2 to 6, wherein the side walls of the deposition chamber comprise a first side wall (111; 211; 311; 411; 511; 611) and a second side wall (112; 212; 312; 412; 512; 612) facing the first side wall, for example a ratio between the distance between the first wall and the second wall to the smallest dimension, for example the width, of the at least one substrate in the deposition chamber is lower than 0.33 or even lower than 0.1, and/or the distance between the first wall and the second wall varying in the direction of the gas flow (20) in the deposition chamber.

8. The deposition apparatus according to any of claims 1, 3 to 7, or the method according to any of claims 2 to 7, wherein the deposition chamber (101; 201) has a trapezoidal-prism or a parallelepipedal shape, the deposition chamber further comprises a third wall (113; 213) joining the first and second side walls, the third wall for example facing an open end (114; 214) of the deposition chamber.

9. The deposition apparatus according to claim 8, or the method according to claim 8, wherein a first distance (g3) between the first wall (211) and the second wall (212) at an open end (214) of the deposition chamber facing the third wall (213) is lower than a second distance (g4) between the first wall and the second wall at the third wall (213) of the deposition chamber.

10. The deposition apparatus according to any of claims 1, 3 to 7, or the method according to any of claims 2 to 7, wherein the deposition chamber (301; 401; 501; 601) has a ring shape or a spiral shape.

11. The deposition apparatus according to 10, or the method according to 10, wherein the first side wall is an inner side wall (311; 411; 511; 611), and the second side wall is an outer side wall (312; 412; 512; 612) positioned around the inner side wall, the inner and outer walls being at least partially tubular, for example the inner and outer walls being at least partially coaxial.

12. The deposition apparatus according to claim 11, or the method according to claim 11, wherein the at least one substrate comprises a substrate tape (30) which is adapted to translate along one (312; 412; 512) of the inner and outer side walls on a way out and along the other one (311; 411; 511) of the inner and outer side walls on a way back, the first part (31A) corresponding to a portion of the substrate tape which is on the way out and the second part (31B) corresponding to another portion of the substrate tape which is on the way back.

13. The deposition apparatus according to claim 11, or the method according to claim 11, wherein the at least one substrate comprises a substrate tape (60) which is adapted to translate along one (612) of the inner and outer side walls and a tubular substrate (70) which is adapted to translate along the other one (611) of the inner and outer side walls, the first part (61) corresponding to the deposition surface of the substrate- tape and the second part (71) corresponding to the deposition surface of the tubular substrate.

14. The deposition apparatus according to any of claims 1, 3 to 13, or the method according to any of claims 2 to 13, wherein the transport system comprises a plurality of guiding rollers (132, 137, 133; 331, 332, 333, 334; 431, 432; 531, 532, 533; 631, 632, 633) arranged in such a way to guide the at least one substrate (10; 30; 60, 70) along the side walls of the deposition chamber (101; 201; 301; 401; 501; 601), for example at least one of the guiding rollers being positioned inside the deposition chamber and at least another one of the guiding rollers being positioned outside the deposition chamber.

15. The deposition apparatus according to claim 14, or the method according to claim 14, wherein at least one of the guiding rollers is permeable to the gas flow, for example at least one of the guiding rollers comprises through-holes (130) through which the gas flow is adapted to be removed from the deposition apparatus.

16. The deposition apparatus according to any of claims 1, 3 to 15, or the method according to any of claims 2 to 15, wherein a closed chamber (144; 304; 604) outside the deposition chamber and in contact with one or more of the side walls of the deposition chamber is under vacuum, for example a vacuum lower than 10⁻⁴ mbar.

17. The deposition apparatus according to any of claims 1, 3 to 16, or the method according to any of claims 2 to 16, wherein a cover wall (150) is positioned over an open end (114) of the deposition chamber (101), the cover wall being heated, for example with heating elements (155) embedded in said cover wall, at a second temperature lower than the first temperature, for example the cover wall is traversed by the precursor inlet (160).

18. The deposition apparatus according to any of claims 1, 3 to 17, or the method according to any of claims 2 to 17, wherein an infrared shielding (640) is positioned around the deposition chamber (601).
